# EUROPÄISCHE PATENTSCHRIFT

(11) **EP 1 626 433 B1**
(45) Veröffentlichungstag und Bekanntmachung des Hinweises auf die Patenterteilung: **21.02.2007**
(21) Anmeldenummer: 04018926.8
(22) Anmeldetag: 10.08.2004
(51) Int. Cl.: H01J 37/34

(54) **Magnetronsputtereinrichtung, Zylinderkathode und Verfahren zur Aufbringung von dünnen Mehrkomponentenschichten auf einem Substrat**
Magnetron sputtering device, cylinder cathode and a method of applying thin multi-component films to a substrate
Appareillage de pulvérisation magnétron, cathode cylindrique et méthod de depot des multicouches minces sur un substrat

(43) Veröffentlichungstag der Anmeldung: 15.02.2006
(73) Patentinhaber: Applied Materials GmbH & Co. KG, 63755 Alzenau (DE)
(72) Erfinder: Liehr, Michael, Dr., 36325 Feldatal (DE)
(74) Vertreter: GROSSE BOCKHORNI SCHUMACHER

(56) Entgegenhaltungen:
- EP-A- 0 703 599
- EP-A- 1 251 547
- DD-A- 217 964
- US-A- 4 356 073
- US-A- 5 180 434
- US-A- 5 466 355
- US-A- 5 507 931

## Beschreibung

Die Erfindung betrifft eine Magnetronsputtereinrichtung und ein Verfahren zur Aufbringung von dünnen Mehrkomponentenschichten auf einem Substrat gemäß den Oberbegriffen von Anspruch 1 bzw. Anspruch 9.

Magnetronsputtereinrichtungen, d.h. Targets mit Magnetanordnungen, die es ermöglichen, in Richtung eines Substrates zu sputtern, sind seit längerem in der Anwendung in Vakuumbeschichtungsanlagen zur Beschichtung von verschiedenen Substraten bekannt und für die Beschichtung mit den verschiedensten Schichtmaterialien geeignet. Solche Vakuumbeschichtungsanlagen umfassen Arbeitskammern in denen die Beschichtung erfolgt. Diese Vakuumkammern weisen einen Basisdruck in einem erforderlichen Vakuumbereich auf, der entsprechend der Prozessparameter insbesondere eine Verunreinigung während der Schichtabscheidung verhindert. Während der Beschichtung weisen die Vakuumkammern einen Arbeitsdruck auf, der deutlich über dem Basisdruck liegen kann und durch das Prozessgas bedingt ist.

Insbesondere Magnetronsputtereinrichtungen mit Zylindermagnetrons weisen eine vorteilhaft hohe Ausnutzungsrate des Targetmaterials und eine lange Tragetstandzeit auf. Zur Anwendung kommen dabei Zylinderkathoden die vollständig aus einem Targetmaterial aufgebaut sind, wie sie z.B. die DD 217 964 beschreibt. Andererseits können auch Trägerrohre verwendet werden, die mit einer umlaufend aufgetragenen Schicht aus Targetmaterial versehen sind, wie sie die US 4,356,073 beschreibt, wobei aus der EP 0 703 599 auch Kathoden mit mehreren Zylindersegmenten aus unterschiedlichen Targetmaterialien bekannt sind. Durch eine gleichförmige Rotation der Zylinderkathode wird eine gleichmäßige Erosion des Targetmaterials auf der Zylinderkathodenoberfläche erzielt, da eine lokal konzentrierte Zerstäubung und somit eine Furchenbildung verhindert wird.

Zur Aufbringung von Mehrkomponentenschichten auf einem Substrat, z.B. bei der Herstellung von Photovoltaikabsorbern, wird häufig das Verfahren des Co-Sputterns eingesetzt. Dabei werden die einzelnen Komponenten der Schicht gleichzeitig von verschiedenen Targets gesputtert und auf einem Substrat aufgebracht. Auf dem Substrat vermischen sich diese Komponenten zu einer Mehrkomponentenschicht. Das Co-Sputtern kann auf verschiedene Weise erzielt werden. Beispielsweise können mehrere separate Targets mit unterschiedlichen Materialkomponenten alternierend in Reihe angeordnet sein. Das Substrat wird dann in Abhängigkeit von der gewünschten Schichtdicke so schnell an diesen Targets vorbeigeführt, dass die einzelnen Materialkomponenten sich auf dem Substrat überlagern und so die Mehrkomponentenschicht bilden. Auf diese Weise können weitgehend homogene Schichten gebildet werden. Nachteilig an diesem Verfahren ist es, dass die Vakuumbeschichtungsanlage relativ teuer ist, da viele Einzelkathoden und eine ausgedehnte Vakuumkammer notwendig sind.

Andererseits besteht auch die Möglichkeit, dass nur ein Target verwendet wird, das aus mehreren Bereichen mit den unterschiedlichen Materialkomponenten zusammengesetzt ist. Das Substrat ist in diesem Fall meist ortsfest angeordnet und die einzelnen Komponenten werden gleichzeitig gesputtert und treffen gleichzeitig auf dem Substrat auf, um die Mehrkomponentenschicht zu bilden. Nachteilig an diesem Verfahren sind die komplizierten Targets und die damit verbundenen hohen Kosten. Außerdem können Verunreinigungen in die Mehrkomponentenschicht inkooperiert werden, da die einzelnen Bereiche meist durch Klebemittel zu einem Target vereint werden, welches dem Sputterprozess ebenso unterworfen ist. Zudem sind diese Mehrkomponententargets planar. Bei solchen Planartargets ist aber nur eine geringe Targetausnutzung möglich und sie weisen einen relativ großen Redepositionsbereich auf. Die großen Redepositionszonen bereiten prozesstechnische Schwierigkeiten und führen zu einer schlechteren Schichtqualität auf dem Substrat.

Aufgabe der vorliegenden Erfindung ist es deshalb, eine Magnetronsputtereinrichtung und ein Verfahren zur Verfügung zu stellen, mit denen es möglich ist, Mehrkomponentenschichten auf einem Substrat aufzubringen, wobei die Nachteile des Stands der Technik überwunden werden. Insbesondere ist es Aufgabe der vorliegenden Erfindung, eine kompakte Vakuumbeschichtungsanlage zu ermöglichen und somit die Kosten dieser Anlage zu senken.

Diese Aufgabe wird erfindungsgemäß gelöst durch eine Magnetronsputtereinrichtung gemäß Anspruch 1 und ein Verfahren gemäß Anspruch 9. Vorteilhafte Weiterbildungen der Erfindung sind durch die in den Unteransprüchen enthaltenen Merkmale gekennzeichnet.

Die erfindungsgemäße Magnetronsputtereinrichtung, welche insbesondere mindestens eine Vakuumkammer umfasst und zur Aufbringung von Mehrkomponentenschichten auf einem Substrat vorgesehen ist, ist mit einer um die axiale Längsachse drehbar gelagerten Zylinderkathode und einem Magnetsystem versehen. Das Magnetsystem ist im Innern der Zylinderkathode angeordnet. Die Zylinderkathode umfasst mindestens zwei Segmente mit unterschiedlichen Targetmaterialien und die Magnetronsputtereinrichtung weist Mittel zum Drehen der Zylinderkathode und Mittel zum Verschieben des Substrats auf. Dabei sind die Mittel zum Drehen der Zylinderkathode angepasst, die Zylinderkathode im Wesentlichen kontinuierlich mit einer Geschwindigkeit in Abhängigkeit von der Substratgeschwindigkeit zu drehen, so dass die Targetmaterialien sich auf dem Substrat durchmischen und so mittels Magnetron-Co-Sputtern eine Mehrkomponentenschicht auf dem Substrat abgeschieden wird. Mit Hilfe der Mittel zum Drehen wird die Zylinderkathode also in einer im Verhältnis zur Geschwindigkeit des Substrates beim Verschieben genügend groß gewählten Rotationsgeschwindigkeit um die Längsachse gedreht, so dass eine Mehrkomponentenschicht auf dem Substrat abgeschieden wird. Diese Magnetronsputtereinrichtung kann im Gegensatz zu einer mit vielen in Reihe angeordneten Targets aufgebauten Magnetronsputtereinrichtung sehr kompakt gestaltet werden. Die Vakuumbeschichtungsanlagen können durch den Einsatz der erfindungsgemäßen Magnetronsputtereinrichtung in ihrer Größe deutlich reduziert werden. Dadurch können die Kosten der Anschaffung und des Unterhalts, der neben den reinen Betriebskosten ja auch die Kosten für die benötigte Stellfläche umfasst, verringert werden. Im Gegensatz zu einem planaren Mehrkomponententarget werden Verunreinigungen durch Kleber vermieden. Außerdem ist die Targetausnutzung größer und der Redepositionsbereich geringer, wodurch eine höhere Schichtqualität erzielt wird.

Vorzugsweise sind die Mittel zum Verschieben des Substrats angepasst, das Substrat in Bezug auf die Längsachse der Zylinderkathode senkrecht zu verschieben. So kann eine hohe Homogenität der abgeschiedenen Mehrkomponentenschicht erzielt werden.

Zweckmäßig umfasst die Magnetronsputtereinrichtung mehrere Zylinderkathoden. Mit einer solchen Magnetronsputtereinrichtung lassen sich Mehrkomponentenschichten auf sehr großflächige Substrate aufbringen. Zur Aufbringung verschiedener aufeinanderfolgender Schichten kann es vorteilhaft sein, wenn die Magnetronsputtereinrichtung mehrere verschiedene Zylinderkathoden umfasst, die unterschiedliche Kombinationen von Targetmaterialien aufweisen.

Vorteilhaft ist es, wenn die einzelnen Segmente der Zylinderkathode als Zylindersegmente ausgebildet sind. Jedoch kann es auch notwendig sein, die Segmente an ihrer Außenseite planar auszuführen, wenn die Aufbringung der Segmente z.B. mittels Plasmaspritzen nicht möglich ist. Beispielsweise lassen sich keramische Stoffverbindungen im Plasmaspritzverfahren nicht immer mit einer erforderlichen Materialdichte und -homogenität auf einem Zylindertarget aufbringen.

Insbesondere, wenn die einzelnen Segmente direkt aneinander grenzen, steht eine große Targetfläche für die einzelnen Materialien zur Verfügung. Zur Unterstützung, z.B. bei dünnen oder auch mechanisch ungenügend stabilen Segmenten, können die einzelnen Segmente auf einem Trägerrohr angeordnet sein.

Grundsätzlich können alles Metalle, Metalloxide und Materialien, aus denen wegen Fertigungsproblemen keine selbsttragenden Segmente hergestellt werden können (hierzu zählen insbesondere ITO, IZO, ZAO, Chrom oder Wolfram) auf Trägerrohren aufgebracht werden. Herstellungsverfahren hierfür sind zum Beispiel heiß-isostatisches Pressen, Plasmaspritzen und Bonden oder Kleben. Hingegen können alle Metalle, aus denen man selbsttragende Segmente, zum Beispiel durch Schneiden, Ziehen, Fräsen, Biegen oder Walzen herstellen kann, wobei man die Segmente beispielweise durch Löten oder Schweißen, aber auch durch mechanische Lösungen wie Schwalbenschwanzführungen miteinander zu einem Target verbinden kann, zur Herstellung von Volltargets verwendet werden. Dies gilt insbesondere für Zinn, Zink, Nickel, Kupfer, Aluminium, Silber, Gold, Platin, Molybdän, Titan und Neodym.

Typische Abmessungen für die Zylinderkathodentargets sind Längen von 500 bis 4500 mm, Durchmesser von 100 bis 300 mm und Wandstärken von 1 bis 50 mm.

Zweckmäßig ist es, wenn die Breiten der einzelnen Segmente in Bezug auf die Zylinderkathodenlängsachse in Abhängigkeit von der Sputterausbeute des jeweiligen Targetmaterials an die gewünschte Stöchiometrie der Mehrkomponentenschicht angepasst sind. Dadurch kann die Zylinderkathode in der Magnetronsputtereinrichtung bei konstanter Rotationsgeschwindigkeit betrieben werden.

Das erfindungsgemäße Verfahren zur Aufbringung von Mehrkomponentenschichten auf einem Substrat durch Magnetron-Co-Sputtern in einer Vakuumbeschichtungsanlage wird folgendermaßen ausgeführt. Eine um die axiale Längsrichtung drehbar gelagerte Zylinderkathode, die mindestens zwei Segmente mit unterschiedlichen Materialien umfasst, wird während der Aufbringung der Mehrkomponentenschicht auf dem Substrat um die Längsachse über einem innenliegenden Magnetsystem gedreht. Gleichzeitig wird das Substrat mit einer bestimmten Geschwindigkeit in einer senkrecht zur Zylinderlängsachse liegenden Richtung an der Zylinderkathode vorbeiführt. Diese Substratgeschwindigkeit wird in Abhängigkeit von der Sputterausbeute und der Entfernung der Zylinderkathode vom Substrat so gewählt, dass sich eine gewünschte Dicke der Mehrkomponentenschicht auf dem Substrat einstellt. Die Rotationsgeschwindigkeit der Zylinderkathode wird dabei in Abhängigkeit von der Substratgeschwindigkeit so gewählt, dass die einzelnen Targetsegmente mit den unterschiedlichen Materialkomponenten in schneller Folge gesputtert werden. Aufgrund der in Bezug auf die Substratgeschwindigkeit hohe Rotationsgeschwindigkeit der Zylinderkathode überlagern sich die einzelnen Materialkomponenten örtlich auf dem Substrat und vermischen sich, wodurch eine Mehrkomponentenschicht auf dem Substrat abgeschieden wird.

Gegenüber den bisher verwendeten Verfahren erfolgt die Schichtabscheidung aufgrund der relativ langsamen Substratverschiebung in Bezug auf die schnelle Zylinderkathodenrotation wesentlich homogener und die Schichtdicke kann exakter eingestellt werden.

Zweckmäßig kann die Stöchiometrie der Mehrkomponentenschicht dadurch eingestellt werden, dass die Breiten der einzelnen Segmente in Bezug auf die Zylinderlängsachse in Abhängigkeit von der Sputterausbeute des jeweiligen Targetmaterials unterschiedlich ausgeführt sind und die Zylinderkathode in der Magnetronsputtereinrichtung bei einer gleichmäßigen, also konstanten Rotationsgeschwindigkeit betrieben wird.

Die gleichmäßige Rotationsgeschwindigkeit der Zylinderkathode liegt zweckmäßig im Bereich von 5 - 20 U/min und vorzugsweise bei 10 U/min. Dabei ist zu beachten, dass die optimale Wahl der Rotationsgeschwindigkeit von der Anzahl der Targetsegmente auf der Zylinderkathode abhängt. Je geringer diese Anzahl desto höher muss die Rotationsgeschwindigkeit gewählt werden, um eine ausreichende Durchmischung der einzelnen Komponenten und damit eine hohe Schichtqualität sicher zu stellen.

Vor allem für Substrate, die in Bezug auf die Substratbewegung große Substratbreiten aufweisen, aber auch für große Substratlängen werden vorteilhaft mehrere in der Magnetronsputtereinrichtung angeordnete Zylinderkathoden zur Schichtabscheidung verwendet. So kann die Schichtabscheidung beschleunigt werden. Wenn verschiedene Schichten auf einem Substrat aufgebracht werden sollen, kann es sich außerdem empfehlen, die verschiedenen Mehrkomponentenschicht in zwei oder mehreren Vakuumkammern aufzubringen.

Gegenüber der Verwendung von mehreren in Reihe angeordneten Targets hat die vorbeschriebene Erfindung den Vorteil, dass durch die Gestaltung des Targets als kompaktes Mehrkomponententarget die Anlagengröße deutlich reduziert ist. So können die Kosten bei der Anschaffung und beim Unterhalt der Beschichtungsanlage reduziert werden. Im Gegensatz zur Verwendung eines kompliziert gestalteten planaren Mehrkomponententargets ist die erfindungsgemäße Zylinderkathode einfacher herzustellen und damit kostengünstiger. Außerdem wird mit ihr eine höhere Targetausnutzung und eine deutlich geringere Redeposition erreicht und die Schichteigenschaften verbessert.

Im folgenden wird ein Ausführungsbeispiel anhand einer Zeichnung näher erläutert, darin zeigen
- Fig. 1: eine perspektivische Ansicht einer erfindungsgemäßen Zylinderkathode, die vollständig aus Targetmaterial aufgebaut ist und
- Fig. 2: eine perspektivische Ansicht einer erfindungsgemäßen Zylinderkathode, deren Targetmaterialien auf einem Trägerrohr aufgebracht sind.

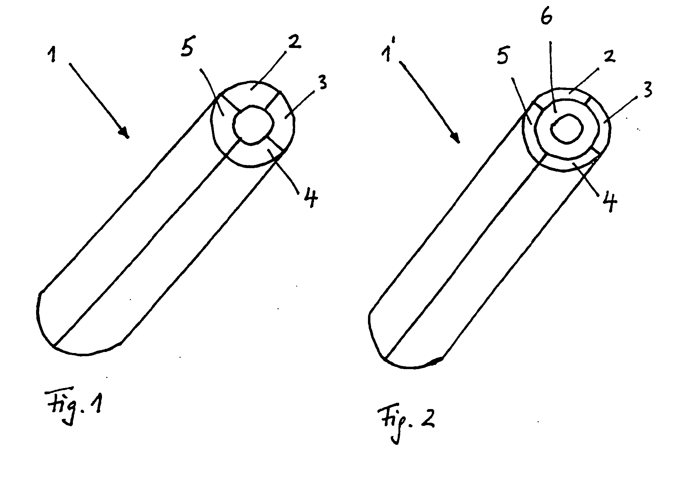

Die erfindungsgemäße Zylinderkathode 1 gemäß Fig. 1 ist als Zylinderrohr ausgebildet. Die Zylinderkathode 1 besteht vollständig aus Targetmaterial und umfasst im dargestellten Fall zwei Targetmaterialien. Jedes Targetmaterial befindet sich in zwei gesonderten Zylindersegment 2, 4 und 3, 5, die sich gegenüberliegen. Die vier Segmente 2, 3, 4 und 5 weisen jeweils einen Kreisbogen von 90° auf und eine gemeinsame Länge, die der Länge der Zylinderkathode 1, 1' entspricht. Zur Bildung der Zylinderkathode 1 werden die Segmente mittels Verschweißen, Löten oder mechanischen Lösungen wie beispielsweise einer Schwalbenschwanzführung direkt miteinander verbunden.

Wenn das Material aufgrund seiner Eigenschaften oder des Herstellungsprozesses einen direkten Aufbau der Zylinderkathode aus Targetmaterial nicht zulässt, wird die Zylinderkathode 1' auf einfache Weise durch Auftragen von verschiedenem Targetmaterial auf einen Trägerrohr 6 gebildet, wie in Fig. 2 dargestellt. Die einzelnen Zylindersegmente 2', 3', 4' und 5' können z.B. durch Plasmaspritzen auf dem Trägerrohr 6 aufgebracht sein. Sie grenzen direkt aneinander und weisen eine gleiche Länge und gleiche Kreisbögen von 90° auf.

Zur Verwendung in einer erfindungsgemäßen Magnetronsputtereinrichtung sind die Zylinderkathoden 1 und 1' mit geeigneten Mitteln (nicht gezeigt) versehen, die die Lagerung der Zylinderkathoden 1 und 1' über einem in ihrem Inneren angeordneten bekannten Magnetsystem sowie eine axialsymmetrische Drehbewegung um ihre Längsachse gestatten.

Zur Aufbringung einer Mehrkomponentenschicht wird das Substrat mit einer der gewünschten Schichtdicke der aufzubringende Schicht angepassten Geschwindigkeit senkrecht zur Längsachse der Zylinderkathode 1 bewegt. Gleichzeitig wird die Zylinderkathode 1 rotiert. Bei jeder Umdrehung der Zylinderkathode 1 werden die Zylindersegmenten 2, 3, 4 und 5 an dem innenliegenden Magnetsystem vorbeigeführt und dabei aus diesen Zylindersegmenten in schneller Folge Material gesputtert. Dieses Material wird unterstützt vom bekannten Magnetroneffekt auf dem Substrat aufgebracht. Da die Rotationsgeschwindigkeit der Zylinderkathode 1 wesentlich größer ist als die Geschwindigkeit des Substrates, überlagern sich die einzelnen Materialkomponenten örtlich auf dem Substrat. Aufgrund dieser Überlagerung vermischen sich die einzelnen Materialkomponenten und eine Mischkomponentenschicht wird auf dem Substrat gebildet.

Natürlich können auch zwei oder mehr Segmente zur Bildung der Zylinderkathoden 1 und 1' verwendet werden, wenn es erforderlich ist. Die Stöchiomerie der Mehrkomponentenschicht kann auch bei gleichförmiger Rotationsgeschwindigkeit der Zylinderkathoden 1 und 1' dadurch eingestellt werden, dass die Breite der Zylindersegment in Abhängigkeit von der Sputterausbeute der einzelnen Materialkomponenten entsprechend angepasst wird. Andererseits ist es aber auch denkbar, dass die Stöchiometrie über eine ungleichförmige Rotationsgeschwindigkeit eingestellt wird.

Für großflächige Substrate können mehrere Zylinderkathoden 1, 1' in einer Magnetronsputtereinrichtung zum Einsatz kommen. In einer Prozesskette können wiederum mehrere Vakuumkammern mit Magnetronsputtereinrichtungen, die mit jeweils verschiedenen Zylinderkathoden 1, 1' mit unterschiedlichen Kombinationen von Targetmaterialien versehen sind, nacheinander angeordnet sein, um verschiedenen Mehrkomponentenschichten in Folge auf einem Substrat aufzubringen.

Mit der vorliegenden Erfindung ist es somit möglich, die Aufbringung von Mehrkomponentenschichten auf Substraten mittels Magnetronsputtern in Vakuumbeschichtungsanlagen mit deutlich reduzierter Anlagengröße zu erreichen. Durch die Verwendung der Zylinderkathode 1, 1' wird eine hohe Targetausnutzung und eine hohe Schichtqualität erzielt.

## Patentansprüche

1. Magnetronsputtereinrichtung, insbesondere mit mindestens einer Vakuumkammer, zur Aufbringung von dünnen Mehrkomponentenschichten auf einem Substrat, die mit einer um die axiale Längsachse drehbar gelagerten Zylinderkathode (1, 1') und einem im Inneren der Zylinderkathode (1, 1') angeordneten Magnetsystem versehen ist, wobei die Zylinderkathode (1, 1') mindestens zwei Segmente (2, 2', 3, 3', 4, 4', 5, 5') mit unterschiedlichen Targetmaterialien umfasst und die Magnetronsputtereinrichtung Mittel zum Drehen der Zylinderkathode (1, 1') und Mittel zum Verschieben des Substrats relativ zur Zylinderkathode aufweist, **dadurch gekennzeichnet, dass** die Mittel zum Drehen der Zylinderkathode (1, 1') angepasst sind, die Zylinderkathode (1, 1') im Wesentlichen kontinuierlich mit einer Geschwindigkeit in Abhängigkeit von der Substratgeschwindigkeit zu drehen , so dass die Targetmaterialien sich auf dem Substrat durchmischen und so mittels Magnetron-Co-Sputtern eine Mehrkomponentenschicht auf dem Substrat abgeschieden wird.

2. Magnetronsputtereinrichtung gemäß Anspruch 1, **dadurch gekennzeichnet, dass** die Mittel zum Verschieben des Substrats angepasst sind, das Substrat in einer Richtung senkrecht zur Längsachse der Zylinderkathode (1, 1') zu verschieben.

3. Magnetronsputtereinrichtung gemäß Anspruch 1 oder 2, **dadurch gekennzeichnet, dass** die Magnetronsputtereinrichtung mehrere Zylinderkathoden (1, 1') umfasst.

4. Magnetronsputtereinrichtung gemäß Anspruch 3, **dadurch gekennzeichnet, dass** die Zylinderkathoden (1, 1') unterschiedliche Kombinationen von Targetmaterialien aufweisen.

5. Magnetronsputtereinrichtung gemäß einem der vorherigen Ansprüche , **dadurch gekennzeichnet, dass** die einzelnen Segmente (2, 2', 3, 3', 4, 4', 5, 5') der Zylinderkathode (1, 1') als Zylindersegmente ausgebildet sind.

6. Magnetronsputtereinrichtung gemäß einem der vorherigen Ansprüche, **dadurch gekennzeichnet, dass** die einzelnen Segmente (2, 2', 3, 3', 4, 4', 5, 5') der Zylinderkathode (1, 1') direkt aneinander grenzen.

7. Magnetronsputtereinrichtung gemäß einem der vorherigen Ansprüche, **dadurch gekennzeichnet, dass** die einzelnen Segmente (2', 3', 4', 5') der Zylinderkathode (1') auf einem Trägerrohr (6) angeordnet sind.

8. Magnetronsputtereinrichtung gemäß einem der vorherigen Ansprüche, **dadurch gekennzeichnet, dass** die Breiten der einzelnen Segmente (2, 2', 3, 3', 4, 4', 5, 5') der Zylinderkathode (1, 1') in Bezug auf die Zylinderkathodenlängsachse in Abhängigkeit von der Sputterausbeute des jeweiligen Targetmaterials an die gewünschte Stöchiometrie der Mehrkomponentenschicht angepasst sind.

9. Verfahren zur Aufbringung von dünnen Mehrkomponentenschichten auf einem Substrat in einer Vakuumbeschichtungsanlage durch Magnetron-Co-Sputtern, mit einer um die axiale Längsachse drehbar gelagerten Zylinderkathode (1, 1') in einer Magnetronsputtereinrichtung, **dadurch gekennzeichnet, dass**
die Zylinderkathode (1, 1') mindestens zwei Segmente (2, 2', 3, 3', 4, 4', 5, 5') mit unterschiedlichen Materialien umfasst und während der Aufbringung der Schichten auf dem Substrat um die Längsachse über dem innenliegenden Magnetsystem gedreht wird,
das Substrat an der Zylinderkathode (1, 1') während des Sputterprozeses vorbeigeführt wird,
die Substratgeschwindigkeit in Abhängigkeit von der Sputterausbeute und der Entfernung der Zylinderkathode (1, 1') vom Substrat so gewählt wird, dass sich eine gewünschte Dicke der Mehrkomponentenschicht auf dem Substrat einstellt und
die Rotationsgeschwindigkeit der Zylinderkathode (1, 1') in Abhängigkeit von der Substratgeschwindigkeit so gewählt wird, dass die einzelnen Targetsegmente (2, 2', 3, 3', 4, 4', 5, 5') in schneller Folge gesputtert werden, sich die unterschiedlichen Materialkomponenten örtlich auf dem Substrat überlagern und mischen und so eine Mehrkomponentenschicht auf dem Substrat abgeschieden wird.

10. Verfahren gemäß Anspruch 9, **dadurch gekennzeichnet, dass** die Zylinderkathode (1, 1') gemäß einem der Ansprüche 4 bis 7 ausgeführt ist.

11. Verfahren gemäß Anspruch 9 oder 10, **dadurch gekennzeichnet, dass** das Substrat senkrecht zur Längsachse der Zylinderkathode (1, 1') bewegt wird.

12. Verfahren gemäß einem der Ansprüche 9 bis 11, **dadurch gekennzeichnet, dass** die Zylinderkathode (1, 1') mit einer gleichmäßigen Rotationsgeschwindigkeit bewegt wird.

13. Verfahren gemäß Anspruch 12, **dadurch gekennzeichnet, dass** die Rotationsgeschwindigkeit der Zylinderkathode 5 - 10 U/min und vorzugsweise 10 U/min beträgt.

14. Verfahren gemäß einem der Ansprüche 9 bis 13, **dadurch gekennzeichnet, dass** die Stöchiometrie der Mehrkomponentenschicht **dadurch** eingestellt wird, dass die Breiten der verschiedenen Materialsegmente (2, 2', 3, 3', 4, 4', 5, 5') in Abhängigkeit von der Sputterausbeute unterschiedlich gewählt sind.

15. Verfahren gemäß einem der Ansprüche 9 bis 14, **dadurch gekennzeichnet, dass** verschiedene Mehrkomponentenschichten von mehreren in der Magnetronsputtereinrichtung angeordneten Zylinderkathoden (1, 1') auf dem Substrat aufgebracht werden.

16. Verfahren gemäß einem der Ansprüche 9 bis 15, **dadurch gekennzeichnet, dass** verschiedene Mehrkomponentenschichten von mehreren, in mindestens zwei Vakuumkammern in der Beschichtungsanlage angeordneten Magnetronsputtereinrichtungen auf dem Substrat aufgebracht werden, wobei das Substrat die einzelnen Vakuumkammern ohne Unterbrechung des Vakuums durchläuft.

## Claims

1. A magnetron sputtering device, particularly comprising at least one vacuum chamber, for coating thin multicomponent films on a substrate, said device having a cylindrical cathode (1, 1') rotatably mounted around the longitudinal axis and having a magnetic system disposed within said cylindrical cathode (1, 1'), said cylindrical cathode (1, 1') comprising at least two segments (2, 2', 3, 3', 4, 4', 5, 5') having different target materials, and said magnetron sputtering device having means for rotating said cylindrical cathode (1, 1') and means for shifting the substrate relative to said cylindrical cathode, **characterized in that** said means for rotating said cylindrical cathode (1, 1') are adapted to rotate said cylindrical cathode (1, 1') essentially continuously at a speed which depends on the substrate speed such that said target materials are intermixed on said substrate, thereby depositing a multicomponent film on said substrate by means of magnetron co-sputtering.

2. A magnetron sputtering device in accordance with claim 1, **characterized in that** said means for shifting said substrate are adapted to shift said substrate in a direction perpendicular to the longitudinal shaft of said cylindrical cathode (1, 1').

3. A magnetron sputtering device in accordance with claims 1 or 2, **characterized in that** said magnetron sputtering device comprises a plurality of cylindrical cathodes (1, 1').

4. A magnetron sputtering device in accordance with claim 3, **characterized in that** said cylindrical cathodes (1, 1') comprise different combinations of target materials.

5. A magnetron sputtering device in accordance with any of the preceding claims, **characterized in that** said individual segments (2, 2', 3, 3', 4, 4', 5, 5') of said cylindrical cathode (1, 1') are designed as cylindrical segments.

6. A magnetron sputtering device in accordance with any of the preceding claims, **characterized in that** said individual segments (2, 2', 3, 3', 4, 4', 5, 5') of said cylindrical cathode (1, 1') adjoin one another directly.

7. A magnetron sputtering device in accordance with any of the preceding claims, **characterized in that** said individual segments (2', 3', 4', 5') of said cylindrical cathode (1') are disposed on a carrier tube (6).

8. A magnetron sputtering device in accordance with any of the preceding claims, **characterized in that** the widths of said individual segments (2, 2', 3, 3', 4, 4', 5, 5') of said cylindrical cathode (1, 1') are adapted to the desired stoichiometry of the multicomponent film relative to the longitudinal shaft of said cylindrical cathode as a function of the sputtering yield of the respective target material.

9. A method of coating thin multicomponent films on a substrate in a vacuum coating system by means of magnetron co-sputtering, having a cylindrical cathode (1, 1') rotatably mounted around the axial longitudinal shaft and positioned within a magnetron sputtering device, **characterized in that**
said cylindrical cathode (1, 1') comprises at least two segments (2, 2', 3, 3', 4, 4', 5, 5') having different materials and is rotated around the longitudinal shaft above the internal magnetic system while the films are being coated on the substrate,
said substrate is guided past said cylindrical cathode (1, 1') during sputtering,
the substrate speed is chosen as a function of the sputtering yield and the distance of said cylindrical cathode (1, 1') from said substrate in such a way that said multicomponent film obtains a desired thickness on said substrate, and
the rotational speed of said cylindrical cathode (1, 1') is chosen as a function of the substrate speed in such a way that said individual target segments (2, 2', 3, 3', 4, 4', 5, 5') are sputtered in rapid succession, and the various material components are superimposed and intermixed locally on said substrate, thereby depositing a multicomponent film on said substrate.

10. A method in accordance with claim 9, **characterized in that** said cylindrical cathode (1, 1') is designed in accordance with any of claims 4 to 7.

11. A method in accordance with claims 9 or 10, **characterized in that** said substrate is moved perpendicular to the longitudinal shaft of said cylindrical cathode (1, 1').

12. A method in accordance with any of claims 9 to 11, **characterized in that** said cylindrical cathode (1, 1') is moved at an even rotational speed.

13. A method in accordance with claim 12, **characterized in that** the rotational speed of said cylindrical cathode is 5 - 10 rpm and preferably 10 rpm.

14. A method in accordance with any of claims 9 to 13, **characterized in that** the stoichiometry of said multicomponent film is adjusted **in that** the widths of said different material segments (2, 2', 3, 3', 4, 4', 5, 5') are chosen to vary as a function of the sputtering yield.

15. A method in accordance with any of claims 9 to 14, **characterized in that** various multicomponent films are coated on said substrate by a plurality of cylindrical cathodes (1, 1') positioned within said magnetron sputtering device.

16. A method in accordance with any of claims 9 to 15, **characterized in that** various multicomponent films are coated on said substrate by a plurality of magnetron sputtering devices positioned in at least two vacuum chambers within said coating system, said substrate passing through said individual vacuum chambers without interrupting the vacuum.

## Revendications

1. Dispositif de pulvérisation magnétron, comprenant en particulier au moins une chambre à vide, pour le dépôt de couches minces à plusieurs composants sur un substrat, qui est équipé d'une cathode cylindrique (1, 1') disposée de manière à pouvoir tourner autour de l'axe longitudinal et d'un système magnétique disposé à l'intérieur de la cathode cylindrique (1, 1'), dans lequel la cathode cylindrique (1, 1') comprend au moins deux segments (2, 2', 3, 3', 4, 4', 5, 5') ayant différentes matières de cible et le dispositif de pulvérisation magnétron présente des moyens pour faire tourner la cathode cylindrique (1, 1') et des moyens pour déplacer le substrat par rapport à la cathode cylindrique, **caractérisé en ce que** les moyens pour faire tourner la cathode cylindrique (1, 1') sont conçus pour faire tourner la cathode cylindrique (1, 1') essentiellement en continu à une vitesse qui dépend de la vitesse du substrat, de sorte que les matières de cible se mélangent sur le substrat et qu'une couche à plusieurs composants est ainsi déposée sur le substrat au moyen d'une co-pulvérisation magnétron.

2. Dispositif de pulvérisation magnétron selon la revendication 1, **caractérisé en ce que** les moyens pour déplacer le substrat sont conçus pour déplacer le substrat dans une direction perpendiculaire à l'axe longitudinal de la cathode cylindrique (1, 1').

3. Dispositif de pulvérisation magnétron selon la revendication 1 ou 2, **caractérisé en ce que** le dispositif de pulvérisation magnétron comprend plusieurs cathodes cylindriques (1, 1').

4. Dispositif de pulvérisation magnétron selon la revendication 3, **caractérisé en ce que** les cathodes cylindriques (1, 1') présentent différentes combinaisons de matières de cible.

5. Dispositif de pulvérisation magnétron selon l'une quelconque des revendications précédentes, **caractérisé en ce que** les segments individuels (2, 2', 3, 3', 4, 4', 5, 5') de la cathode cylindrique (1, 1') sont réalisés en forme de segments cylindriques.

6. Dispositif de pulvérisation magnétron selon l'une quelconque des revendications précédentes, **caractérisé en ce que** les segments individuels (2, 2', 3, 3', 4, 4', 5, 5') de la cathode cylindrique (1, 1') sont directement adjacents les uns aux autres.

7. Dispositif de pulvérisation magnétron selon l'une quelconque des revendications précédentes, **caractérisé en ce que** les segments individuels (2', 3', 4', 5') de la cathode cylindrique (1') sont disposés sur un tube support (6).

8. Dispositif de pulvérisation magnétron selon l'une quelconque des revendications précédentes, **caractérisé en ce que** les largeurs des segments individuels (2, 2', 3, 3', 4, 4', 5, 5') de la cathode cylindrique (1, 1') par rapport à l'axe longitudinal des cathodes cylindriques sont adaptées à la stoechiométrie souhaitée de la couche à plusieurs composants en fonction du rendement de pulvérisation de chaque matière de cible.

9. Procédé de dépôt de couches minces à plusieurs composants sur un substrat dans une installation de dépôt sous vide par co-pulvérisation magnétron, comprenant une cathode cylindrique (1, 1') disposée de manière à pouvoir tourner autour de l'axe longitudinal dans un dispositif de pulvérisation magnétron, **caractérisé en ce que**
- la cathode cylindrique (1, 1') comprend au moins deux segments (2, 2', 3, 3', 4, 4', 5, 5') ayant différentes matières et tourne pendant le dépôt des couches sur le substrat autour de l'axe longitudinal au-dessus du système magnétique situé à l'intérieur,
- le substrat passe devant la cathode cylindrique (1, 1') pendant le processus de pulvérisation,
- la vitesse du substrat est choisie, en fonction du rendement de pulvérisation et de l'éloignement de la cathode cylindrique (1, 1') par rapport au substrat, de manière à ajuster une épaisseur souhaitée de la couche à plusieurs composants sur le substrat et
- la vitesse de rotation de la cathode cylindrique (1, 1') est choisie, en fonction de la vitesse du substrat, de manière à ce que les segments individuels de la cible (2, 2' , 3, 3' , 4, 9' , 5, 5') soient pulvérisés coup sur coup, que les différents composants de matières s'accumulent localement sur le substrat et se mélangent et qu'une couche à plusieurs composants soit ainsi déposée sur le substrat.

10. Procédé selon la revendication 9, **caractérisé en ce que** la cathode cylindrique (1, 1') est réalisée selon l'une quelconque des revendications 4 à 7.

11. Procédé selon la revendication 9 ou 10, **caractérisé en ce que** le substrat est déplacé perpendiculairement à l'axe longitudinal de la cathode cylindrique (1, 1').

12. Procédé selon l'une quelconque des revendications 9 à 11, **caractérisé en ce que** la cathode cylindrique (1, 1') est déplacée à une vitesse de rotation constante.

13. Procédé selon la revendication 12, **caractérisé en ce que** la vitesse de rotation de la cathode cylindrique est de 5 à 10 tr/min et de préférence de 10 tr/min.

14. Procédé selon l'une quelconque des revendications 9 à 13, **caractérisé en ce que** la stoechiométrie de la couche à plusieurs composants est ajustée en choisissant différemment les largeurs des segments de matières différentes (2, 2', 3, 3', 4, 4', 5, 5') en fonction du rendement de pulvérisation.

15. Procédé selon l'une quelconque des revendications 9 à 14, **caractérisé en ce que** différentes couches à plusieurs composants de plusieurs cathodes cylindriques (1, 1') disposées dans le dispositif de pulvérisation magnétron sont déposées sur le substrat.

16. Procédé selon l'une quelconque des revendications 9 à 15, **caractérisé en ce que** différentes couches à plusieurs composants de plusieurs dispositifs de pulvérisation magnétron, disposés dans au moins deux chambres à vide de l'installation de dépôt, sont déposées sur le substrat, le substrat traversant les chambres à vide individuelles sans casser le vide.
